# EUROPEAN PATENT APPLICATION

(11) **EP 3 091 581 A1**
(43) Date of publication of application: **09.11.2016**
(21) Application number: 15166385.3
(22) Date of filing: 05.05.2015
(51) Int. Cl.: H01L 31/054, H01L 31/05, H01L 31/0687, H01L 31/0725, H01L 31/0304

(54) **SOLAR CELL MODULE AND METHOD FOR FABRICATING A SOLAR CELL MODULE**

(71) Applicant: SolAero Technologies Corp., Albuquerque, NM 87123 (US)
(72) Inventor: Derkacs, Daniel, Albuquerque, NM New Mexico 87111 (US); Aiken, Daniel, Cedar Crest, NM New Mexico 87008 (US); Sharps, Paul R., Albuquerque, NM New Mexico 87112 (US)
(74) Representative: Maikowski & Ninnemann Patentanwälte Partnerschaft mbB

(57) **Abstract**

A solar cell module and method for fabricating the same are provided. The solar cell module, comprising: a support (302, 600, 701); a plurality of solar cells (301, 601-605) mounted on the support, so as to form an array of solar cells (301, 601-605) on the support, and interconnection components (410) electrically connecting at least some of the solar cells (301, 601-605) in series, wherein each of the solar cells (301, 601-605) has an area of about 0.01 mm² to 9 cm², in particular between 0.25 mm² and 1 cm², more particular between 1 mm² and 25 mm².

## Description

### BACKGROUND OF THE INVENTION

### 1. Field of the Invention

The present invention relates to photovoltaic devices such as solar cell assemblies for use in space, and methods for fabricating the same.

### 2. Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have efficiencies that exceed 27% under one sun, air mass 0 (AM0), illumination, whereas even the most efficient silicon technologies generally reach only about 18% efficiency under comparable conditions. Under high solar concentration (e.g., 500X), commercially available III-V compound semiconductor multijunction solar cells in terrestrial applications (at AM1.5D) have energy efficiencies that exceed 37%. The higher conversion efficiency of III-V compound semiconductor solar cells compared to silicon solar cells is in part based on the ability to achieve spectral splitting of the incident radiation through the use of a plurality of photovoltaic regions.

Typical III-V compound semiconductor solar cells are fabricated on a semiconductor wafer in vertical, multijunction structures. The individual solar cells or wafers are then disposed in horizontal arrays, with individual solar cells connected together in one or more electrical series circuits. The shape and structure of an array, as well as the number of cells it contains, are determined in part by the desired output voltage and current.

In satellite and other space related applications, the size, mass and cost of a space vehicle or satellite power system are dependent on the power and energy conversion efficiency of the solar cells used. Putting it another way, the size of the payload and the availability of on-board services are proportional to the amount of power provided. Thus, as payloads become more sophisticated and require more power, both the power-to-weight ratio (measured in watts per kg) and power-to-area ratio (measured in watts per square meter) of a solar cell array or panel become increasingly more important, and there is increasing interest in lighter weight, densely packed solar cell arrays having both high efficiency and low mass.

Conventional space solar array panels at present are most often comprised of a relatively densely packed arrangement of large solar cells formed from group III-V compound semiconductor devices mounted on a rigid supporting panel and operating without lenses for optical concentration of sunlight. A conventional space solar array panel may include a support, space solar cells disposed on the support, and interconnection components for connecting the solar cells, and bypass diodes also connected to the solar cells. Close packing of the large solar cells on the space solar array panel is challenging due to requirement for interconnection of the solar cells to form a series circuit and to implement and interconnect the bypass diodes on the panel. An additional challenge can sometimes reside in the need to interconnect a plurality of strings of series connected solar cells in parallel.

Solar cells are often produced from circular or substantially circular wafers sometimes 100 mm or 150 mm in diameter. Large solar cells (i.e. with, for example, an area from 25 to 60 cm² representing one-quarter or more of the area of the wafer) are conventionally preferred so as to minimize the costs associated with the assembly of the solar cells onto a support to form a solar cell module. However the use of large solar cells results in poor wafer utilization, and large solar cells are poor in overall average efficiency on large numbers of lots, and are fragile and present handling challenges during subsequent fabrication steps that results in breakage and lower manufacturing yield. Moreover, large solar cells of predetermined size cannot be easily or efficiently accommodated on panels of arbitrary aspect ratios or configurations.

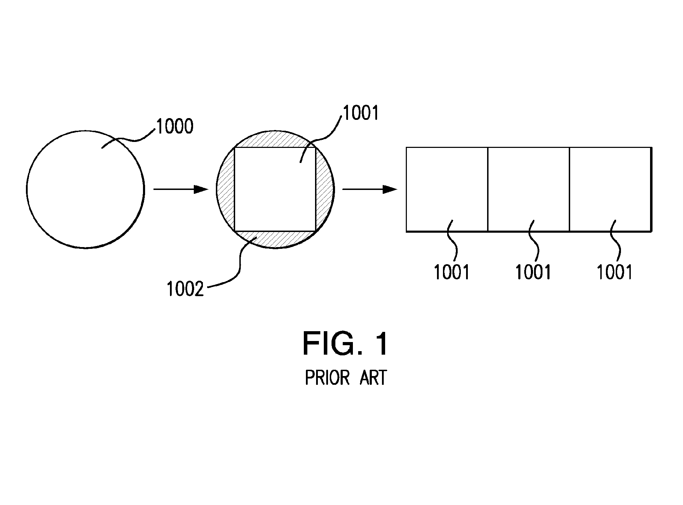

The poor wafer utilization is illustrated in FIG. 1, which shows how out of a circular solar cell wafer 1000 a generally rectangular solar cell 1001 is obtained, leaving the rest of the wafer as waste 1002. This inefficiency substantially increases the cost of a solar cell array of a given area in view of the fact that the cost of fabricating III-V compound semiconductor multijunction solar cell wafers is expensive per unit area.

The degradation in overall average efficiency is due to the fact that the performance of a solar cell is often affected by the fact that although small material defects may be present only in a small region of the processed wafer, such defects affect the efficiency or performance of the entire solar cell. These material quality defects often cannot be removed or mitigated, and results in lower overall average efficiency over large numbers of solar cell lots.

Although concentration optics may increase the efficiency of III-V compound semiconductor multijunction solar cells and the optical power generated per cell, space photovoltaic arrays at present generally do not include concentration optics because of deployability problems, optical complexity problems, and reliability problems in space due to, for example, the uneven heating.

### SUMMARY

It is an object of the disclosure to provide a space solar array utilizing relatively small solar cells so that a larger percentage of the wafer used for fabricating the solar cell is utilized.

It is another object of the disclosure to provide a space solar array that utilizes over 90% of the area of the wafers from which the solar cells are fabricated.

It is another object of the disclosure to provide a space solar array which provides packing density with respect to a given panel area.

It is another object of the disclosure to provide a set of solar cell configurations in different sizes which allow the cells to be adapted to a given panel geometry.

It is still another object of the disclosure to provide a module (or "MIC") with a plurality of relatively small solar cells connected in parallel and/or in series.

It is still another object of the disclosure to provide a module (or "MIC") which may be closely packed adjacent to other modules.

It is still another object of the disclosure to provide a module (or "MIC") which includes electrical and mechanical connectors that allow each module to be securely connected to an adjacent module and form a series electrical connection.

It is still another object of the disclosure to provide a module (or "MIC") which includes electrical and mechanical connectors that allow each module to be securely connected to adjacent modules on all four sides of each module.

It is still another object of the disclosure to provide a module (or "MIC") which includes electrical and mechanical connectors that minimize light loss on the overall top surface of each module.

It is still another object of the disclosure to provide a module including an array of solar cells and an optical element disposed over each respective solar cell.

It is still another object of the disclosure to provide a module including an array of small solar cells and an optical element providing a concentration in the range of 1X to 10X concentration over the cells.

It is still another object of the disclosure to provide an array of solar cells disposed on a modular substrate which is mechanically and/or electrically pluggable into adjacent solar cell modules.

It is still another object of the disclosure to provide a solar cell module wherein the solar cells are interconnected in series and/or in parallel by wires.

It is still another object of the disclosure to provide a method for fabricating a solar cell module that makes efficient use of a solar cell wafer.

It is still another object of the disclosure to provide a method for fabricating a solar cell module that allows for efficient use of the wafer material without incorporating the material corresponding to a defective region of the solar cell wafer.

Some implementations of the present disclosure may incorporate or implement fewer of the aspects and features noted in the foregoing objects.

According to an embodiment of the present disclosure, there is provided a solar cell module, comprising: a plurality of solar cells mounted on a support, so as to form an array of solar cells on the support, each of the solar cells having an area of about 0.01 mm² to 9 cm²; interconnection components for electrically connecting at least a part of the solar cells in series. In other embodiments each solar cell has an area between 0.25 mm² and 1 cm², in particular between 1 mm² and 25 mm². In some embodiments of the disclosure, the solar cell module further comprises concentration optics for concentrating light to the solar cells with a concentration rate greater than 1 and equal to or less than about 10 in particular with a concentration rate between 2 and 8, more particular a concentration rate between 3 and 7. In some embodiments, the solar cells each may have an area of about 0.1 mm² to 100 mm².

In some embodiments of the disclosure, at least one, preferably all concentrating elements of a concentration optics comprise a first and second face, the two faces being substantially parallel to each other. The first end facing the respective solar cell and the second end facing away from said solar cell and arranged for receiving sunlight. Walls extend between said first and said second end, said first end having a smaller surface area than said second end. The walls can have e.g. a curved shape, a shape combined from line elements or another complex shape.

In some embodiments of the disclosure, at least one, preferably each of said concentrating elements has a substantially trapezoidal cross section, the first end facing the respective solar cell and the second end facing away from said solar cell and arranged for receiving sunlight, and oblique walls extending between said first and said second end, said first end having a smaller surface area than said second end. This is a special case of the embodiment with two parallel faces. In further embodiments at least one of the concentration elements has a first end facing the respective solar cell with an area between 1.1 and 2 times larger than the second end facing away from the solar cell. In some embodiments, a plurality of said concentrating elements are arranged so that they substantially abut against adjacent concentrating elements at their second end while they are substantially spaced from adjacent concentrating elements at their first end. Thus, the concentrating elements can receive a large proportion, such as 100% or close to 100% of the sunlight received at the solar module, and direct all or most of it onto the solar cells. However, the solar cells can be spaced from each other, allowing ample space on the support for the incorporation of bypass diodes, contacts, interconnecting components, etc. Thus, efficient use of sunlight can be combined with a layout with space for components between adjacent solar cells.

According to another embodiment of the present disclosure, there is provided a method for fabricating a solar cell module, comprising: providing a support and providing a plurality of solar cells; arranging the solar cells in an array on the support, each of the solar cells having an area of about 0.01 mm² to 9 cm², in particular between 0.25 mm² and 1 cm², more particular between 1 mm² and 25 mm²; and electrically connecting at least some of the solar cells in series. In some embodiments of the disclosure, the method further comprises the step of attaching concentration optics on the solar array for concentrating light to the solar cells with a concentration rate greater than 1 and equal to or less about 10, , in particular with a concentration rate between 2 and 8, more particular a concentration rate between 3 and 7.

In some embodiments of the disclosure, the method comprises the step of obtaining at least a plurality of the solar cells by dividing, for example cutting, at least one solar cell wafer into at least 10 substantially square or rectangular solar cells, such as into at least 100 or into at least 500 solar cells or more. In some embodiments of the disclosure, after dividing said at least one solar cell wafer into a plurality of substantially square or rectangular solar cells, some of said solar cells are selected so as not to be used for producing the solar cell module; the solar cells selected not to be used for producing the solar cell module may correspond to a defective region of the solar cell wafer. Thereby, overall efficiency of the solar cell module is enhanced.

In some embodiments, the cell size is 100 µm to 3 cm; in the case of a rectangular solar cell, cell size refers to the length of the longest side of the solar cell; in the case of a square solar cell, cell size refers to the length of the side of the solar cell.

In some embodiments, the cell size is 500 µm to 1 cm.

In some embodiments, the cell size is 1 mm to 5 mm.

In some embodiments, the cell size is 2 mm to 4 mm.

In some embodiments, the MIC size (with "MIC" referring to the discrete module with an array of cells mounted on a frame or support) is 25 mm x 25 mm to 60 mm by 600 mm.

In some embodiments, the MIC size is 50 mm x 50 mm to 300 mm by 300 mm.

In some embodiments, the MIC size is 100 mm x 100 mm to 200 mm by 200 mm.

In some embodiments, the cell density (cell and lens/reflector top down area counts as 1 cell) is 2000 to .25 cells/cm².

In some embodiments, the cell density (cell and lens/reflector top down area counts as 1 cell) is 200 to .5 cells/cm².

In some embodiments, the cell density (cell and lens/reflector top down area counts as 1 cell) is 5 to 1 cells/cm².

Such concepts are unique in their use of both low concentration and very small solar cells as mentioned above, as compared with conventional space solar arrays. Small cells produced from a large (i.e., 100-150 mm) wafer results in higher wafer utilization, by as much as 50% over conventional large space cells. Small cells allow small point defects to be feasibly removed from the population, promising a consistently high yield. Further, small cells have inherently higher efficiency than large cells. Small cells of a single design can be the building block for large custom PV modules, resulting in standardization of the solar cell product. Also, small cells enable advanced processes such as epitaxial lift-off. Small cells may obviate the need for grid fingers, and their associated practical production difficulties. Small cells promote the use of automation such as for cell testing and automated panel assembly methods, and may reduce the need for touch labour. Small cells may minimize the effect of the integration of CTE mismatched materials, thus widening the choices of materials such as adhesives and cover glasses. Small solar cells can be interconnected by wires, using standard wire bonding techniques and standard equipment for wire bonding. In some embodiments of the disclosure, the solar cells are interconnected in series and/or in parallel, using wires. This can sometimes be preferred over the use of more or less complex interconnects and specific machinery and/or steps for welding the interconnects to the solar cells. In some embodiments of the disclosure, ball bonding, wedge bonding or compliant bonding is used for interconnecting the solar cells with wires.

On the other hand, concentration can dramatically reduce the cost of the solar cells used in the array, even at low concentration values such as 2-3X. Concentration can result in higher solar cell performance. Concentration, and the light steering that results, can virtually eliminate metallic contact shading of the cell, parasitic illumination of inactive cell perimeter, as well as parasitic illumination of cell interconnects and bypass diodes. The packing factor of the PV array can converge on 100%. These losses would otherwise make the small cells described herein infeasible from a performance perspective, thus small cells work well together with concentration. Low concentration (as opposed to medium or high concentration) obviates additional tracking infrastructure beyond what is already used for flat panel space arrays. In some embodiments of the disclosure, the solar array features a concentrator coverage factor of more than 90%, 95% or 99% sometimes in the order of 100%, whereas the coverage factor of the solar cells with a concentrator element and mounted in a spaced apart manner on a support is substantially lower, such as less than 80%, or even less. Thereby, the incoming solar light is used efficiently whereas the space between the solar cells reduces the cost of the solar cell material needed for the array, and at the same time allows for the placement of components such as bypass diodes.

In some embodiments of the disclosure, the solar cell module is for use in space.

### BRIEF DESCRIPTION OF THE DRAWINGS

The accompanying drawings, which are incorporated in and constitute a part of the specification, illustrate embodiments of the disclosure and, together with the description, serve to explain the principles of the disclosure.
Fig. 1 is a plan view illustrating a conventional solar cell die with large area being cut out from a wafer.
Fig. 2 is a plan view illustrating small solar cell dies cut out from a wafer according to an embodiment of the present disclosure.
Figs. 3A through 3D are simplified sectional views partly illustrating a single solar cell in a solar cell module with concentration optics according to various embodiments of the present disclosure.
Fig. 4 is a simplified sectional view illustrating two adjacent solar cells in a solar cell module with concentration optics according to one embodiment of the present disclosure.
Fig. 5A is a perspective view of a space solar cell module with concentration optics according to one embodiment of the present disclosure.
Fig. 5B is a perspective view illustrating a solar cell module with concentration optics according to another embodiment of the present disclosure.
Fig. 5C is a cross-sectional view of a solar cell module according to another embodiment of the present disclosure.
Fig. 6 is a simplified sectional view illustrating a solar cell module with small solar cells and concentration optics according to an embodiment of the present disclosure.
Fig. 7 is a simplified perspective view of a solar cell module of Fig. 6.
Fig. 8 is a simplified perspective view illustrating a solar cell module with small solar cells and concentration optics according to an embodiment of the present disclosure.
Fig. 9 is a flowchart representing a method in accordance with an embodiment of the disclosure.

Further aspects, features and advantages of the present invention will be understood from the following description with reference to the drawings.

### DESCRIPTION OF THE EMBODIMENTS

In a solar cell module such as a space solar cell module with small space solar cells according to an embodiment of the present disclosure, the module may include a support, which can be either rigid or flexible, for supporting solar cells as well as other components, such as interconnection components and/or bypass diodes, on a surface thereof. Space solar cells can be attached to the support, and the solar cells according to the present disclosure can be smaller, even much smaller, than the conventional ones as mentioned above. In some embodiments, the solar cells according to the present disclosure may each have an area of about 0.1 mm² to about 100 mm², which is more than ten times less than the conventional space solar arrays having solar cells with an area of 25 to 60 cm².

In some embodiments, the solar cell may have a substantially square or rectangular shape with a dimension (width and/or length) of about 100 µm to 3 cm, in some embodiments, 500 µm to 1 cm, in some embodiments, 1 mm to 5 mm. In other words, the solar cell may have an area of about 0.01 mm² to 9 cm², in some embodiments, about 0.25 mm² to 1 cm², in some embodiments, about 1 mm² to 25 mm². The MIC (the module including an array of cells mounted on a sheet or a support) may have dimensions of about 25 mm by 25 mm to about 600 mm by 600 mm. In some embodiments, the MIC may be about 50 mm by 50 mm to 300 mm by 300m. In some embodiments, the MIC may be 100 mm by 100 mm to 200 mm by 200 mm.

In other words, in some embodiments of the disclosure the module may have an area of about 600 mm² to 3600 cm², in some embodiments about 25 cm² to 900 cm², in some embodiments 100 cm² to 400 cm².

It is possible to reduce the amount of waste and at the same time achieve a high fill factor by dividing a circular or substantially circular wafer not into one single rectangular, such as square, cell, but into a large number of smaller cells. By dividing a circular or substantially circular wafer into a large amount of relatively small cells, such as rectangular cells, most of the wafer material can be used to produce solar cells, and the waste is reduced. For example, a solar cell wafer having a diameter of 100 mm or 150 mm and a surface area in the order of 80 cm² or 180 cm² can be used to produce a large amount of small solar cells, such as square or rectangular solar cells each having a surface area of less than 9 cm², less than 1 cm², less than 0.1 cm² or even less than 0.05 cm² or less than 0.01 cm². For example, substantially rectangular -such as square- solar cells can be obtained in which the sides are less than 30, 10, 5, 3, 2, 1 or even 0.5 mm long. Thereby, the amount of waste of wafer material can be substantially reduced, and at the same time a high fill factor can be obtained.

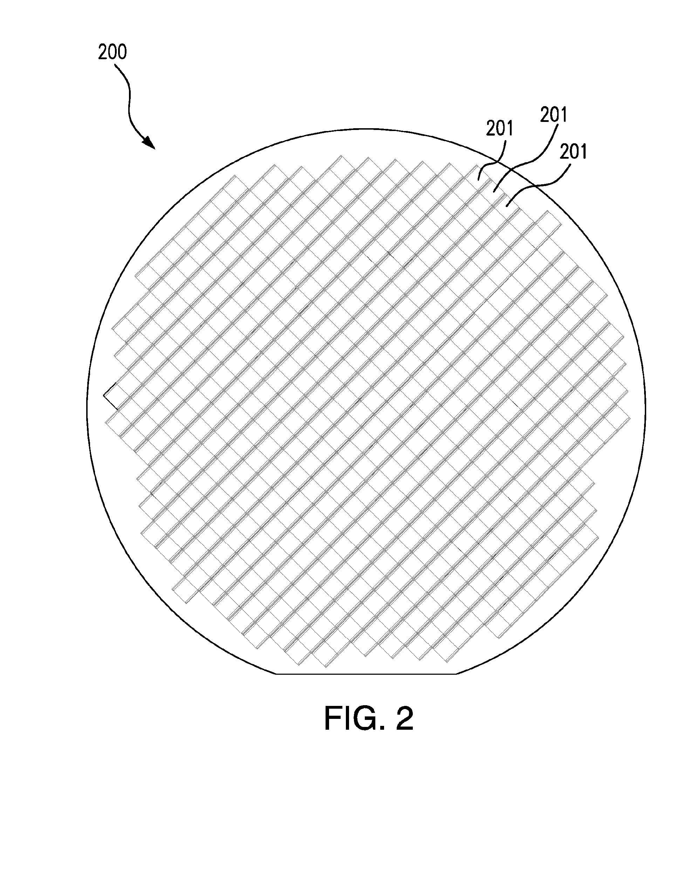

Fig. 2 is a plan view illustrating dies 201 with relatively small areas being defined to be diced or cut out from a wafer 200 according an embodiment of the present disclosure. The solar cells 201 may each have an area as described above, for example, of about 0.1 mm² to about 100 mm². As shown, the wasted area of the wafer 200 which cannot be used to fabricate solar cells 201 is significantly reduced compared to that of Fig. 1. Specifically, the wafer utilization may be from 88% to 95%. Also, solar cells 201 corresponding to a defective region of the wafer can easily be discarded so as not to impair the performance of the module produced from the solar cells.

The solar cell module may further comprise concentration optics for concentrating light to the solar cells. In some preferred embodiments, the concentration rate of the concentration optics is low, for example, greater than 1 and equal to or less than about 10, in particular between 2 and 8, more particular between 3 and 7.

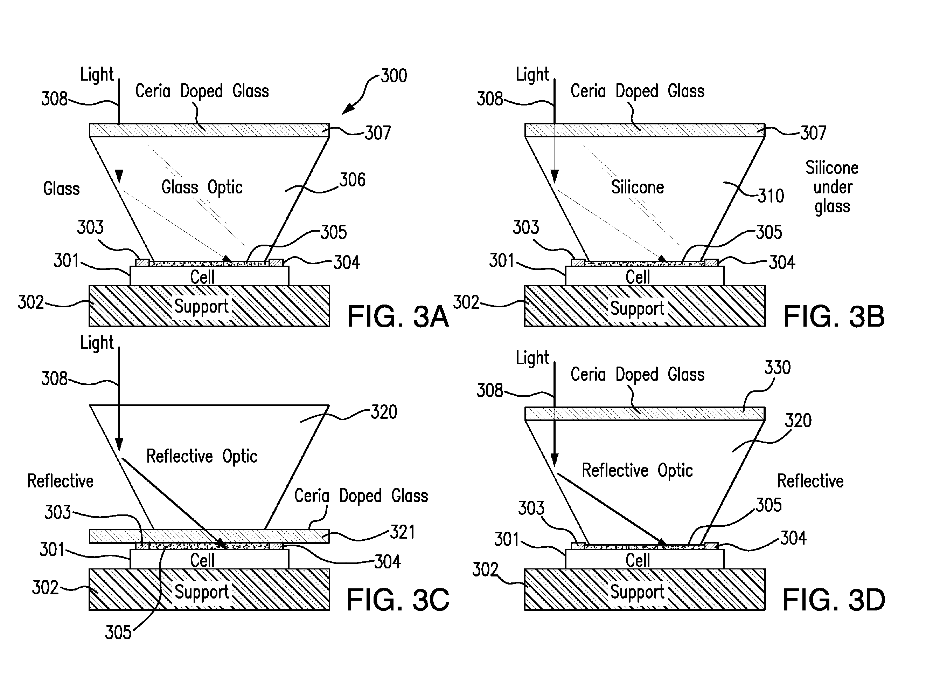

Figs. 3A through 3D are simplified sectional views partly illustrating a single solar cell assembly in a module utilizing small space solar cells and concentration optics according to various embodiments of the present disclosure. The small solar cells 301 are mounted on a support 302.

In the embodiment of Fig. 3A, the concentration optic 306 of the single solar cell assembly 300 is implemented with glass optic 306 (a concentrating element) which is disposed over the solar cell 301. The incident light 308 that is not directed to the light receiving surface of solar cell 301 can be reflected or totally internal reflected (TIR) at the side faces of the glass optic 306 to the light receiving surface of the solar cell. The geometry (for example, shape, dimensions, and the like) of the glass optic 306 can be varied as long as it can direct light to the light-receiving surface of the solar cell, although it is shown in Fig. 3A as an upside-down trapezoid in cross-sectional view with oblique side-faces. In other embodiments instead of oblique side-faces (or walls) curved walls, facetted walls comprising more than one linear element or complex shaped walls are used. In either case concentration optics, here the glass optic 306, have first and second end faces which are essentially parallel to each other, the first end face facing the solar cell, the second end face facing away from the solar cell. The glass optic 306 can be bonded to the corresponding cell 301 with a bonding layer 305, which in the illustrated embodiment of Fig. 3A is placed between two contacts 303 and 304 of the solar cell 301. These contacts can comprise contact pads or bus bars. The bonding layer 305 can be formed from any suitable bonding materials known in the art, and thus it is omitted from being discussed in detail. In some embodiments, a ceria doped glass layer 307 can be provided on the upper surface of the glass optic 306; this ceria doped glass layer can extend over the entire solar array, that is, covering all of the concentrators 306 of the solar array, or some of them.

In another implementation, shown in Fig. 3B, the concentrating optics 310 can be implemented with resin material(s), for example, silicone. Here, as in other embodiments described below, the concentration optics comprise concentration elements 306, 310, 320. The solar cell assembly may further include a layer (for example, a ceria-doped glass layer 307) disposed over the concentrating optics 310 so as to enhance the transmission of the incident light and/or to protect the concentrating optics 310. The concentrating optic 310 is bonded to the cell by the bonding layer 305, extending between the two upper contacts 303 and 304. The geometry (for example, shape, dimensions, and the like) of the optic 310 can be varied as long as it can direct light 308 to the light-receiving surface of the solar cell 301, although it is shown in Figs. 3A-3D as a prism in cross-sectional view with oblique side-faces. The embodiment shown in Fig. 3B can comprise concentration optics comprising concentration elements 310 with the same geometrical features which are described in connection with the embodiment shown in Fig. 3A, in particular the arrangement of the end faces and the side walls.

Fig. 3C is a simplified sectional view partly illustrating a space solar assembly with small space solar cells and concentration optics 320 according to an embodiment of the present disclosure. In the embodiment of Fig. 3C, the concentration optic 320 is implemented with reflective optic 320 which is placed on top of the solar cell 301. The incident light 308 that is not directed to the light receiving surface of solar cell 301 can be reflected at the side faces of the reflective optic 320 to the light receiving surface of the solar cell. In some preferred embodiments, the solar cell assembly may further comprise a layer of ceria-doped glass 321 interposed between the optic 320 and the solar cell 301, so as to enhance the transmission of the reflected light to the cell 301. Similarly, the reflective optic 320 or the ceria-doped glass 321 can be attached to the solar cell with a bonding layer 305 arranged between the two upper contacts 303 and 304 of the solar cell 301. The embodiment shown in Fig. 3C can comprise concentration optics comprising concentration element 320 with the same geometrical features which are described in connection with the embodiment described in Fig. 3A, in particular the arrangement of the end faces and the side walls.

In this embodiment, the ceria-doped glass 321 is disposed below the reflective optic 320, and can be bonded to the corresponding cell 301 with a bonding layer 305.

In another implementation in Fig. 3D, a ceria-doped glass 330 can similarly be further disposed over the reflective optic 320. The embodiment shown in Fig. 3D can comprise concentration optics with concentrating elements 320 with the same geometrical features which are described in connection with the embodiment described in Fig. 3A, in particular the arrangement of the end faces and the side walls.

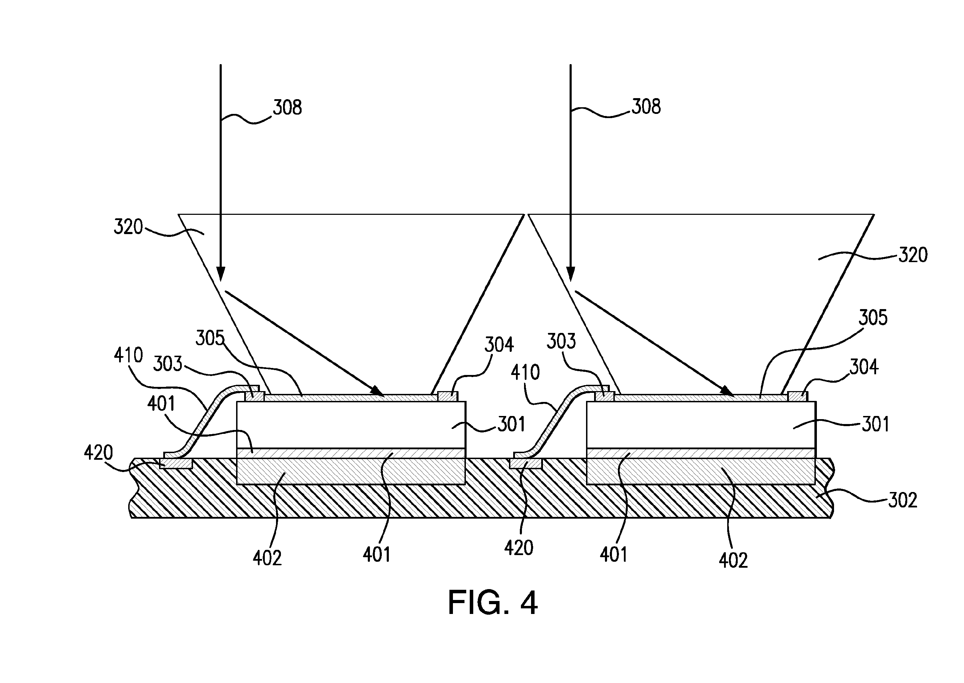

Fig. 4 is a simplified sectional view illustrating a portion of a space solar cell module with small space solar cells and concentration optics 320 according to an embodiment of the present disclosure. The module includes at least two solar cells 301 and concentration optics 320 bonded to the light-receiving surfaces of the solar cells 301, using a bonding layer 305 extending between two upper contacts 303 and 304 of the respective solar cell. An interconnection component 410 is connected to connecting component or upper contact 303 (for example, a contact pad or bus bar or the like) of the cell 301 and to a contact 420 such as a contact pad or bus bar on the support 302. This contact 420 can be connected to a bottom or rear contact of an adjacent solar cell. As discussed in connection with Fig. 3A to 3D, the geometrical shape of the concentration optics with concentration elements 320 can be different in alternative embodiments.

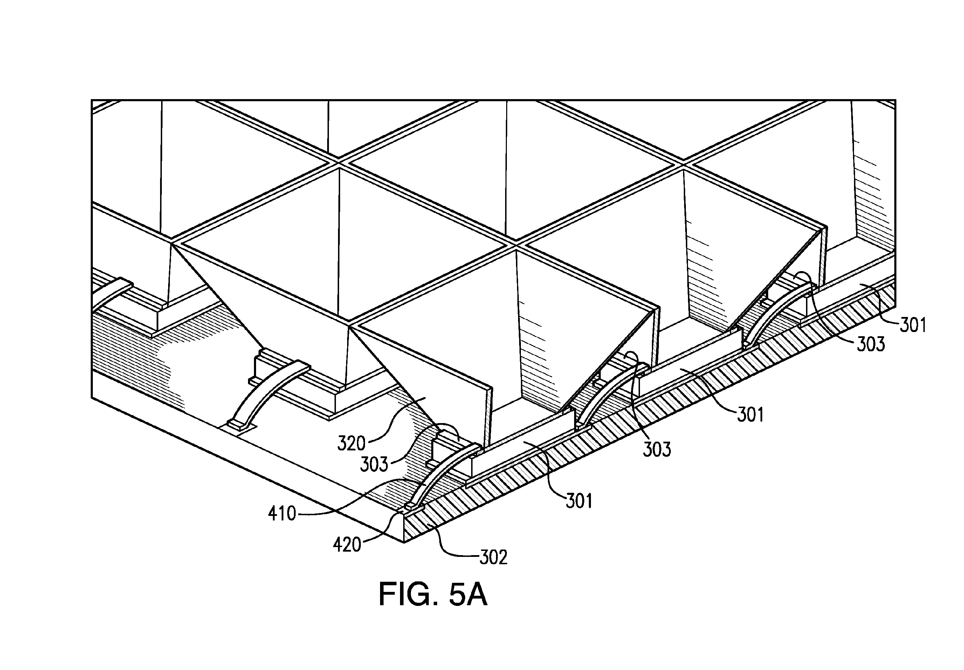

Fig. 5A is a partly-exposed perspective view illustrating a solar cell module with small space solar cells and concentration optics 320 according to an implementation of Fig. 4. The interconnection component 410 is coupled to the connecting component or contact 303 on the cell 301 at one end and to the bonding pad 420 on the support 302 at the other end. In this embodiment, the interconnection component 410 is implemented with an elongated metal sheet which is preferably curved, however, it is to be noted that various interconnection components 410 can be applied. In some embodiments of the disclosure, wires can be used to embody the interconnection components 410. This makes it possible to use standard wire bonding techniques and devices to establish the interconnections, thereby reducing the costs involved with the production of the solar cell module.

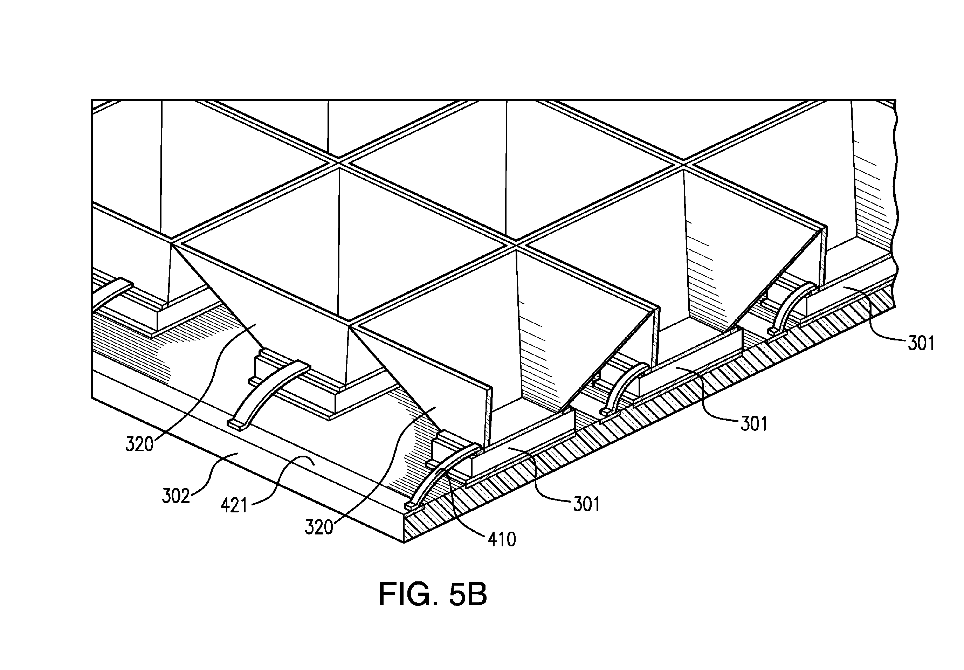

Fig. 5B is a partly-exposed perspective view illustrating a solar cell module with small space solar cells and concentration optics 320 according to an implementation of Fig. 4. The structure of the space solar array of Fig. 5B is similar to that of Fig. 5A, except that the component 420 (contact) is implemented with a strip-like bus bar 421 (i.e. a contact) on the support 302.

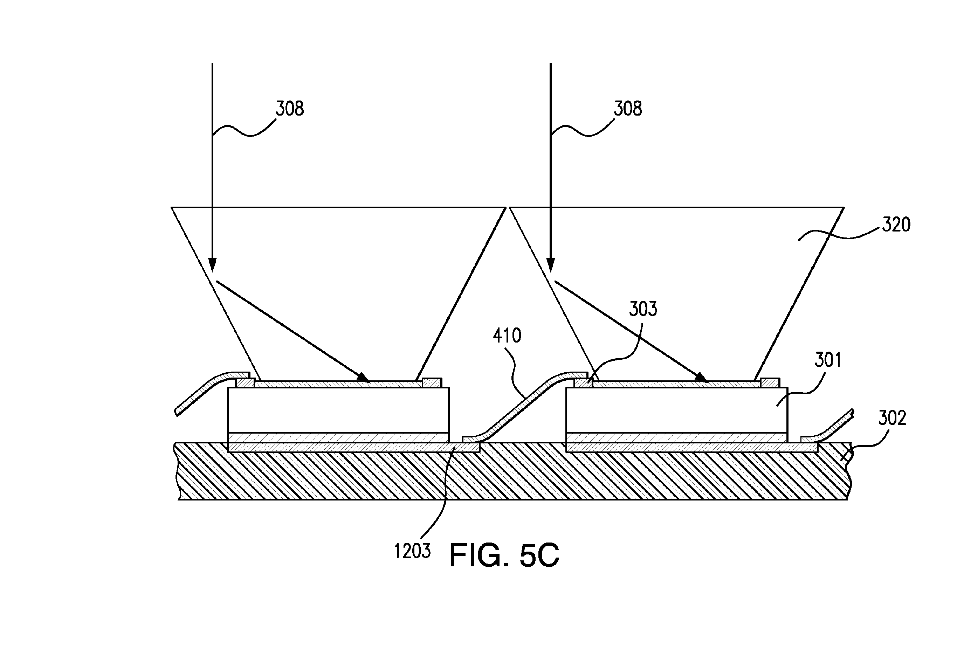

Fig. 5C is a sectional view illustrating another solar cell module with small space solar cells and concentration optics 320 according to an embodiment of the disclosure. As shown, the interconnection component 410 can be connected to the connecting component 303 on a cell 301 at one end, and to a metal trace 1203 (i.e. a contact) under another cell or on the bottom side of the other cell. This metal trace is in contact with a metal contact at the bottom or rear side of said other cell. As discussed in connection with Fig. 3A to 3D, the geometrical shape of the concentration optics 320 in the embodiments shown in Fig. 5A to 5C can be different.

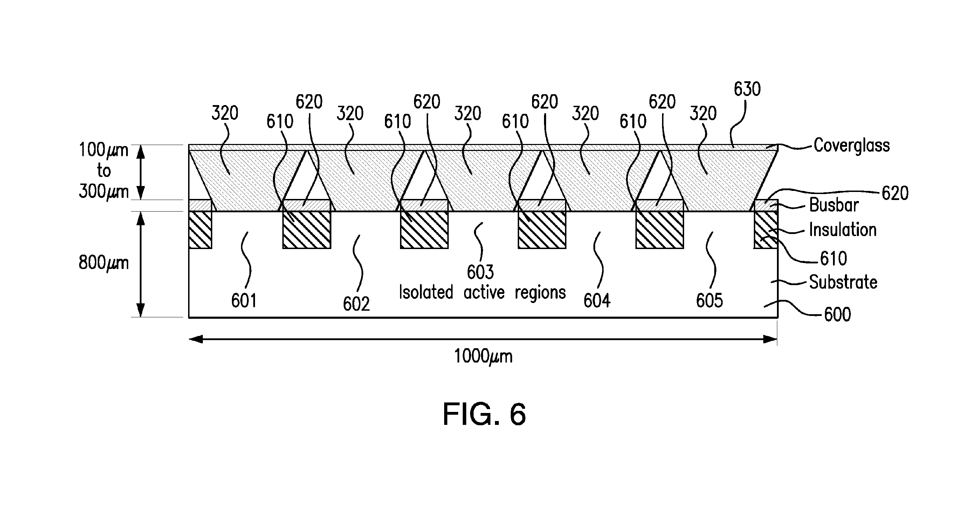

Fig. 6 is a simplified sectional view illustrating a solar module with small space solar cells and concentration optics 320 according to an embodiment of the present disclosure. In this embodiment, solar cells 601, 602, 603, 604, 605 are formed in a substrate (i.e., die or wafer) 600, and isolated with, for example, trenches which are filled with insulation materials 610. An array of concentration optics 320 is disposed over the isolated solar cells 601, 602, 603, 604, 605. A layer 620 can be formed over the trench isolator 610 so as to facilitate the disposition of the optics 301 onto the cells. Also, a ceria-doped glass 630 can be positioned over the optics 320. Please note that various optics can be applied, as mentioned above. In such a case, the substrate itself can function as a support as mentioned above. Further, the substrate(s) can also be positioned on an additional support (not shown).

In an embodiment, the substrate 600 may have a dimension, d1, of about 1000 µm in width or length and a height d2 of about 800µm. In some embodiments, the concentration optics 320 may have a height d3 of about 100 µm to 300 µm above the layer 620 (if any) or above the principle surface of the substrate 600 (in the case that the layer 620 is not present). In some other embodiments, the optics 320 and the ceria-doped glass 630 may collectively have a height d3 of about 100 µm to 300 µm above the layer 620 (if any) or above the principle surface of the substrate 600 (in the case that the layer 620 is not present).

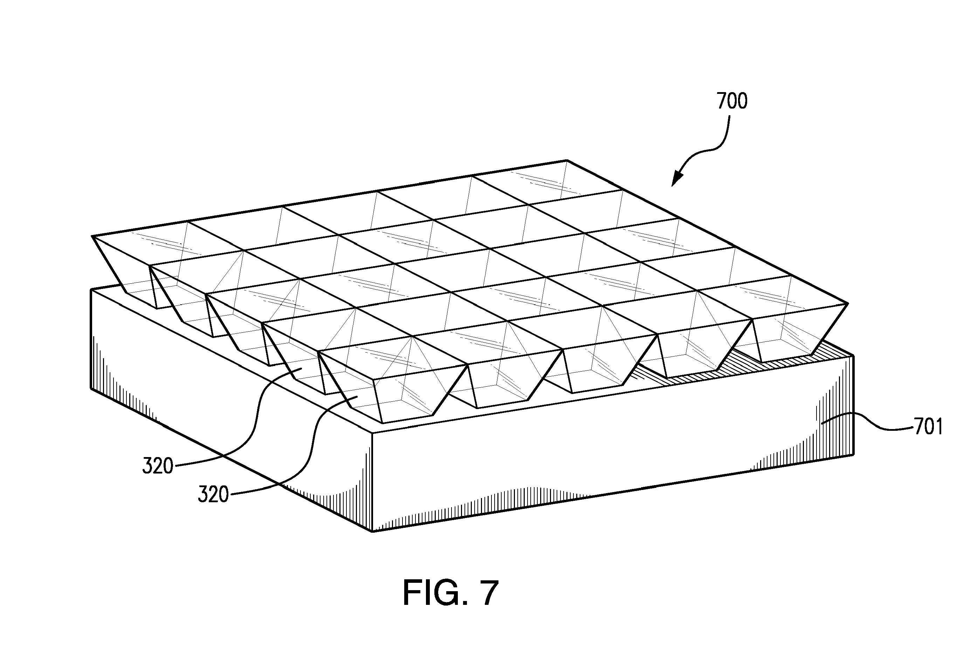

Fig. 7 is a simplified perspective view of a five by five matrix space solar cell module 700 with small space solar cells and concentration optics 320 according to an embodiment of the present disclosure, placed on a support 701. The solar cell module may have a rectangular shape with a length of about 5 to 20 cm and a width of about 5 to 20 cm. In some other embodiments the solar cell module may have a square shape with similar dimensions.

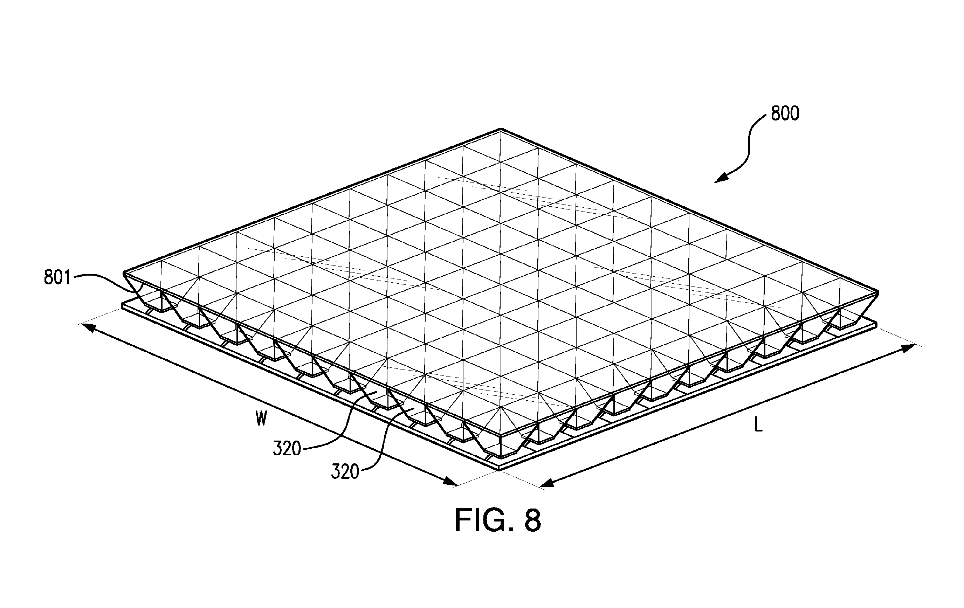

Fig. 8 is a simplified perspective view of a module 800 with a five by five matrix space solar cell array with small space solar cells and concentration optics 320 according to the embodiments of the present disclosure. The solar cell module may have a rectangular shape with a length L of about 5 to 20 cm and width W of about 5 to 20 cm. In some other embodiments the solar cell module may have a square shape with similar dimensions. A coverglass is covering the concentration optics 320.

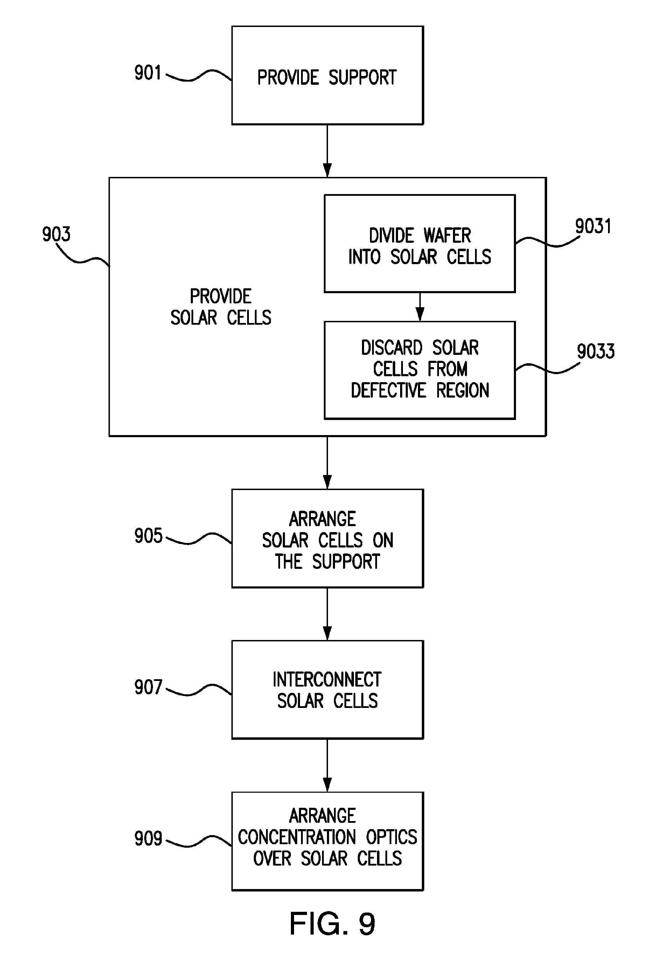

Fig. 9 is a flow chart illustrating a method for fabricating a solar cell assembly with small space solar cells according to an embodiment of the present disclosure. At step 901 a support is provided, at step 903 solar cells are provided, and at step 905 the solar cells are arranged on the support, forming an array. Each of the solar cells can have a light-receiving surface of an area as above mentioned, for example, of about 0.1 mm² to 100 mm². In step 907 at least some solar cells are interconnected in series, for example, using interconnection components for electrically connecting at least a part of the solar cells. Examples of suitable interconnection components include wires, elongated metal sheets, bypass diodes, connectors, or the like. In some embodiments of the disclosure, the wires are attached using wire bonding. In a specific implementation of step 903, the solar cells are obtained by dividing each of one or more solar cell wafers into 10 or more solar cells, such as into more than 100 solar cells, in step 9031, and in a subsequent step 9033 some of the obtained solar cells are discarded, for example, as they are considered to correspond to a defective region of the solar cell wafer. At step 909, concentration optics 306, 310, 320 are attached to the solar cell module for concentrating light to the solar cells with a concentration rate greater than 1 and equal to or less about 10, in particular with a concentration rate between 2 and 8, more particular a concentration rate between 3 and 7.

In an embodiment, the concentration optics 306, 310, 320 may be implemented with reflectors disposed over the interconnection components and reflecting incident light to the respective solar cells. In another embodiment, the concentration optics 306, 310, 320 may be implemented with prisms, such as glass prisms or silicone prisms, for redirecting incident light to the respective solar cells. In yet another embodiment, the concentration optics 306, 310, 320 may be implemented with a refractive lenslet array disposed over the solar cells and refracting incident light to the respective solar cells. In an embodiment, the solar cells themselves may further comprise connectors arranged at least along a side face thereof.

According to the embodiments of the present disclosure, a cell unit density (the footprint area of the solar cell and corresponding optic being counted as one (1) cell unit) of 2000 to 0.5 cell units/cm², preferably, 200 to 0.5 cell unit/cm², and more preferably, 5 to 1 cell units/cm² can be achieved.

It is to be noted that the terms "front", "back", "top" , "bottom", "over", "on", "under", and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Furthermore, those skilled in the art will recognize that boundaries between the above described operations merely illustrative. The multiple units/operations may be combined into a single unit/operation, a single unit/operation may be distributed in additional units/operations, and units/operations may be operated at least partially overlapping in time. Moreover, alternative embodiments may include multiple instances of a particular unit/operation, and the order of operations may be altered in various other embodiments.

In the claims, the word 'comprising' or 'having' does not exclude the presence of other elements or steps then those listed in a claim. The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The fact that certain measures are recited in mutually different claims does not indicate that a combination of these measures cannot be used to advantage.

The present invention can be embodied in various ways. The above described orders of the steps for the methods are only intended to be illustrative, and the steps of the methods of the present disclosure are not limited to the above specifically described orders unless otherwise specifically stated. Note that the embodiments of the present disclosure can be freely combined with each other without departing from the spirit and scope of the invention.

Although some specific embodiments of the present invention have been demonstrated in detail with examples, it should be understood by a person skilled in the art that the above examples are only intended to be illustrative but not to limit the scope of the present invention. It should be understood that the above embodiments can be modified without departing from the scope and spirit of the present invention which are to be defined by the attached claims.

## Claims

1. A solar cell module, comprising:
a support (302, 600, 701),
a plurality of solar cells (301, 601-605) mounted on the support, so as to form an array of solar cells (301, 601-605) on the support, and
interconnection components (410) electrically connecting at least some of the solar cells (301, 601-605) in series,
wherein each of the solar cells (301, 601-605) has an area of about 0.01 mm² to 9 cm², in particular between 0.25 mm² and 1 cm², more particular between 1 mm² and 25 mm².

2. The solar cell module according to claim 1, further comprising concentration optics (306, 310, 320) for concentrating light to the solar cells (301, 601-605) with a concentration rate greater than 1 and equal to or less than about 10, in particular with a concentration rate between 2 and 8, more particular a concentration rate between 3 and 7.

3. The solar cell module according to claim 2, wherein:
the concentration optics comprises a plurality of concentrating elements (306, 310, 320), each of said concentrating elements (306, 310, 320) being placed above a respective solar cell (301, 601-605).

4. The solar cell module according to claim 3, wherein at least one, preferably all of said concentrating elements (306, 310, 320) has a first face and a second faced substantially parallel to each other, a first end facing the respective solar cell (301, 601-605) and a second end facing away from said solar cell (301, 601-605) and arranged for receiving sunlight, and walls extending between said first and said second end, said first end having a smaller surface area than said second end.

5. The solar cell module according to claim 3 to 4, wherein at least one, preferably all of said concentrating elements (306, 310, 320) has a substantially trapezoidal cross section, a first end facing the respective solar cell (301, 601-605) and a second end facing away from said solar cell (301, 601-605) and arranged for receiving sunlight, and oblique walls extending between said first and said second end, said first end having a smaller surface area than said second end.

6. The solar cell module according to at least one of the claims 3 or 5, wherein:
at least one of the concentration elements (306, 310, 320) having the first end facing the respective solar cell (301, 601-605) with an area between 1.1 and 2 times larger than the second end facing away from the solar cell (301, 601-605) .

7. The solar cell module according to at least one of the claims 3 to 6, wherein each of said concentrating elements (306, 310, 320) comprises a solid body of translucent material, or wherein said oblique walls are reflective so as to reflect incoming sunlight arriving at said second end towards said first end and / or wherein a plurality of said concentrating elements (306, 310, 320) are arranged so that they substantially abut against adjacent concentrating elements (306, 310, 320) at their second end while they are substantially spaced from adjacent concentrating elements (306, 310, 320) at their first end.

8. The solar cell module according to any of the preceding claims, wherein:
the interconnection components (410) comprise wires, and wherein at least one of the solar cells (301, 601-605) is electrically connected to at least another one of said solar cells (301, 601-605) by at least one wire which is wire bonded to a contact at an upper surface of one solar cell (301, 601-605), and to a contact (420, 421, 1203) placed on the support and electrically connected to contact at a lower surface of another solar cell (301, 601-605).

9. The solar cell module according to any of the preceding claims,
- wherein each of the solar cells (301, 601-605) has an area of about 0.01 mm² to 100 mm², and/or
- wherein each of the solar cells (301, 601-605) has a substantially square or rectangular shape, and wherein no side is longer than 3 cm
and / or
wherein the solar cells (301, 601-605) are III-V compound semiconductor multijunction solar cells (301, 601-605).

10. A method for fabricating a solar cell module, comprising:
providing a support (302, 701) and providing a plurality of solar cells (301);
arranging said plurality of solar cells (301) in an array on the support; and
electrically connecting at least some of said solar cells (301) in series;
wherein each of the solar cells (301) has an area of about 0.01 mm² to 9 cm², in particular between 0.25 mm² and 1 cm², more particular between 1 mm² and 25 mm².

11. The method according to claim 10, further comprising the step of arranging concentration optics (306, 310, 320) over the solar cells (301) for concentrating light to the solar cells (301) with a concentration rate greater than 1 and equal to or less than about 10, in particular with a concentration rate between 2 and 8, more particular a concentration rate between 3 and 7.

12. The method according to claim 10 or 11, wherein
electrically connecting at least some of said solar cells (301) in series comprises interconnecting at least some of the solar cells (301) in series using wires, wherein interconnecting at least some of the solar cells (301) in series using wires preferably comprises wire bonding a first end of a wire to at least one contact at an upper surface of one of said solar cells (301), and wire bonding a second end of the wire to a contact arranged in correspondence with a surface of the support.

13. The method according to at least one of the claim 10 to 12 wherein
the concentration optics comprise reflectors for reflecting incident light to the respective solar cells (301), or wherein
the concentration optics (306, 310, 320) comprise prisms for redirecting incident light to the respective solar cells (301).

14. The method according to any of claims 10 to 13, comprising the step of obtaining at least a plurality of the solar cells (301) by dividing at least one III-V compound semiconductor multijunction solar cell wafer into at least 10 substantially square or rectangular solar cells (301), preferably into at least 100 substantially square or rectangular solar cells (301).

15. The method according to claim 14, wherein after dividing said at least one III-V compound semiconductor multijunction solar cell wafer into at least 10 substantially square or rectangular solar cells, some of said solar cells (301) are selected so as not to be used for fabricating the solar cell module, the solar cells (301) selected not to be used for fabricating the solar cell module corresponding to a defective region of the at least one solar cell wafer.
